Europäisches Patentamt

European Patent Office

Office européen des brevets

(11) Veröffentlichungsnummer: **0 307 766**
**A1**

## (12) EUROPÄISCHE PATENTANMELDUNG

(21) Anmeldenummer: 88114533.8

(22) Anmeldetag: 06.09.88

(51) Int. Cl.⁴: **H05K 3/40 , H05K 3/34**

(30) Priorität: 09.09.87 DE 3730262
12.08.88 DE 3827473

(43) Veröffentlichungstag der Anmeldung:
22.03.89 Patentblatt 89/12

(84) Benannte Vertragsstaaten:
AT BE CH DE FR GB IT LI NL

(71) Anmelder: Siemens Aktiengesellschaft Berlin
und München
Wittelsbacherplatz 2
D-8000 München 2(DE)

(72) Erfinder: Diekmann, Bernd, Dipl.-Ing. TU
Fröhlichstrasse 12 1/2
D-8900 Augsburg(DE)
Erfinder: Bergmiller, Ludwig, Dipl.-Ing. FH
Enzianstrasse 14
D-8900 Augsburg 21(DE)
Erfinder: Baier, Torsten, Dipl.-Ing. FH
Max-Planck-Strasse 19
D-8900 Augsburg 21(DE)

(54) Leiterplatte zum Bestücken mit SMD-Bausteinen.

(57) Leiterplatte zum Bestücken mit SMD-Bausteinen, aus einem Trägermaterial (1) mit auf mindestens einer Oberfläche angeordneten Kontaktflecken (2) für die SMD-Bausteine, mit einer auf der Oberfläche des Trägermaterials (1) angeordneten nichtmetallische Abdeckschicht (6), in der die Kontaktflecken (2) und eventuelle Prüfpunkte ausgespart (7) sind, sowie in den Aussparungen (7) befindlichem streichfähigem Kontaktierungsmaterial wie Lotpaste oder leitfähigem Kleber.

EP 0 307 766 A1

FIG 4

## Leiterplatte zum Bestücken mit SMD-Bausteinen

Die Erfindung bezieht sich auf eine Leiterplatte zum Bestücken mit SMD-Bausteinen aus einem gegebenenfalls mehrlagigen Trägermaterial und auf mindestens einer Oberfläche angeordneten Lötflekken für die SMD-Bausteine.

Im Zuge der fortschreitenden Miniaturisierung und Automatisierung elektronischer Baugruppen werden in verstärktem Maße sogenannte SMD-Bausteine (surface mounted devices) verwendet, deren Anschlüsse unmittelbar auf die auf einer Oberfläche der Leiterplatte angeordneten Kontaktflecken aufgelötet werden. Dazu wird mit Hilfe eines Siebes oder mit Hilfe einer Schablone im Sieb-/oder Schablonendruckverfahren Lotpaste auf die Kontaktflecken der Oberfläche der Leiterplatte aufgetragen, und die auf der Leiterplatte zu montierenden SMD-Bausteine werden mit Hilfe von Bestückungsmaschinen bzw. Bestückungsautomaten aufgesetzt. Die Herstellung solcher Siebe oder Schablonen für den Sieb-/oder Schablonendruck, ihre Lagerung sowie das Einrichten derselben sind relativ kostenintensiv und nur dann sinnvoll, wenn die Losgröße der für die Bestückung mit SMD-Bausteinen vorzubereitenden Leiterplatten größer als etwa 50 Leiterplatten pro Sieb-/oder Schablonendruck ist. Die Vorbereitung von Leiterplatten zum Bestücken mit SMD-Bausteinen in Losgrößen 1 ist deshalb praktisch nicht möglich.

Ein anderes Problem ist darin zu sehen, daß bei den immer feiner werdenden Strukturen der Kontaktflecken auf den Oberflächen der Leiterplatten die Anwendung von Sieb-/oder Schablonendruckerfahren immer schwieriger wird.

Ein weiteres Problem bei der Bestückung ist, daß diese nicht oder nur sehr begrenzt von Hand durchgeführt werden kann. Es müssen deshalb Bestückungsmaschinen oder Bestückungsautomaten auch bei sehr kleinen Stückzahlen, wie z.B. im Musterbau, eingesetzt und hierfür Aufspannvorrichtungen bzw. Programme für die Bestückungsmaschinen erstellt werden.

Zwischen dem Aufsetzen von SMD-Bausteinen auf die vorbereiteten Kontaktflecken der Leiterplatte und dem Abschluß des Lötvorganges können die SMD-Bausteine durch Erschütterungen bei der Bearbeitung bzw. dem Transport verrutschen, was zu schlechten Lötstellen oder gar Kurzschlüssen zwischen den Anschlüssen führen kann. Um solche Fehler zu vermeiden, sind umfangreiche Maßnahmen erforderlich. Zum Beispiel werden häufig die Kontaktflecken größer als notwendig gemacht, was aber andererseits einen vermehrten Platzverbrauch auf der Leiterplatte bedeutet.

Eine Kurzschlußgefahr zwischen den Kontaktflecken besteht auch durch die mit Hilfe des Sieb-/oder Schablonendruckmusters aufgetragene Lotpaste. Die Menge der auf die Kontaktflecken aufzutragenden Lotpaste muß daher sehr genau dimensioniert werden, Fehler müssen durch individuelles Nacharbeiten beseitigt werden, und es ist ein hoher Kontrollaufwand notwendig.

Nach Fertigstellung einer Flachbaugruppe, d.h. nach der Bestückung der Leiterplatte mit Bauelementen, muß diese einer Prüfung unterzogen werden, wozu vorzugsweise Vakuumadapter benutzt werden. Durchkontaktierungen in den Leiterplatten werden aber bei dem Verlöten der SMD-Bausteine durch Reflow-Lötverfahren nicht geschlossen und eine Anwendung der an sich vorteilhaften Vakuumadapter ist deshalb in diesen Fällen nicht möglich. Vor der Anwendung von Vakuumadaptern müssen deshalb solche Baugruppen entweder zusätzlich durch Schwallöten nachverlötet oder Aufspannadapter anstelle von Vakuumadaptern eingesetzt werden.

Darüber hinaus gibt es noch eine Reihe von weiteren Problemen, die in Verbindung mit dem Bestücken von Leiterplatten mit SMD- Bausteinen auftreten können.

Der vorliegenden Erfindung lag daher die Aufgabe zugrunde, eine Leiterplatte zum Bestücken von SMD-Bausteinen zu schaffen, bei der die auf der/den Oberflächen angeordneten Kontaktflecken für die SMD-Bausteine nicht mit Hilfe des üblicherweise verwendeten Sieb-/oder Schablonendruckverfahrens mit Lotmaterial versehen werden müssen.

Gelöst wird dies in Verbindung mit einer an sich bekannten Leiterplatte mit einer auf der Oberfläche angeordneten nichtmetallische Abdeckschicht, in der die Kontaktflecken und eventuelle Prüfpunkte ausgespart sind, sowie durch in den Aussparungen befindliches Kontaktierungsmaterial. Hierzu ist kein Sieb-/oder Schablonendruck erforderlich, die Strukturen der Kontaktflecken können ferner sehr fein gemacht werden, und außerdem ist ein Versatz zwischen dem Kontaktierungsmaterial und den Kontaktflecken unmöglich. Durch die Aussparungen in der nichtmetallischen Abdeckschicht ist auch ein Einsetzen der SMD-Bauteile von Hand möglich, da die Anschlüsse der SMD-Bauelemente in die Aussparungen der Abdeckschicht gleiten können. Auch das Bestücken von Leiterplatten in sehr kleiner Stückzahl und von Hand ist hierdurch möglich und die Ausführung von Reparaturen wird wesentlich einfacher. Weil die Kontaktflecken in den Aussparungen der nichtmetallischen Abdeckschicht vertieft liegen, wird das SMD-Bauteil seitlich festgehalten und ein Verrutschen verhindert;

2

d.h. die Bearbeitung und der Transport solcher Leiterplatten ist unproblematisch. Dadurch können die Kontaktflecken auf die für die reine Kontaktierung notwendige Größe minimiert werden, und es wird Platz auf der Leiterplatte gewonnen. Da sich das Kontaktierungsmaterial in den Aussparungen der Abdeckschicht befindet, kann es außerdem auch nicht zwischen die Kontaktflecken fließen, wodurch ein Kurzschluß sicher vermieden wird. Durch die Tatsache, daß die Oberfläche der Leiterplatte mit Ausnahme der Kontaktflecken und eventueller Prüfpunkte vollständig durch eine nichtmetallische Abdeckschicht abgedeckt ist, werden zusätzlich die Durchkontaktierungen mit der Abdeckschicht verschlossen und damit die Anwendung der vorteilhaften Vakuumadapter bei der anschließenden Flachbaugruppenprüfung möglich.

Die Vorteile dieser bekannten Leiterplatte können aber nicht voll genutzt werden, wenn auf die Kontaktflecken in den Aussparungen der Abdeckschicht Lotmaterial durch Eintauchen der Leiterplatte in ein Schmelzbad aus einer Zinn-/Bleilegierung aufgebracht wird. Denn dieses Lotmaterial erstarrt ungleichmäßig und muß deshalb noch mit Hilfe von Heißluft nivelliert werden um eine einigermaßen gleichförmige Lotschicht zu erzielen. Aber auch dadurch lassen sich keine völlig gleichen Verhältnisse für alle Anschlüsse eines SMD-Bausteins erzielen.

Der Erfindung lag daher die Aufgabe zugrunde, die bekannte Leiterplatte so zu verbessern, daß zum einen deren oben genannte Nachteile vermieden und zum anderen die Voraussetzungen für ein möglichst rationelles Herstellverfahren geschaffen werden Erfindungsgemäß werden dies dadurch erreicht, daß als Kontaktierungsmaterial ein streichfähiges Material wie Lotpaste oder leitfähiger Kleber vorgesehen ist.

Weitere Einzelheiten der Erfindung ergeben sich aus den Patentansprüchen sowie aus der nachfolgenden Beschreibung eines Ausführungsbeispiels der Erfindung anhand der Zeichnungen, in denen

FIG 1 und 2 den bekannten Aufbau von Leiterplatten und das Vorbereiten zum Bestücken mit SMD-Bausteinen,

FIG 3 den Aufbau einer bekannten verbesserten Leiterplatte und

FIG 4 eine erfindungsgemäße Leiterplatte sowie das Einbringen von Lotpaste in die Aussparungen der Abdeckschicht zeigen.

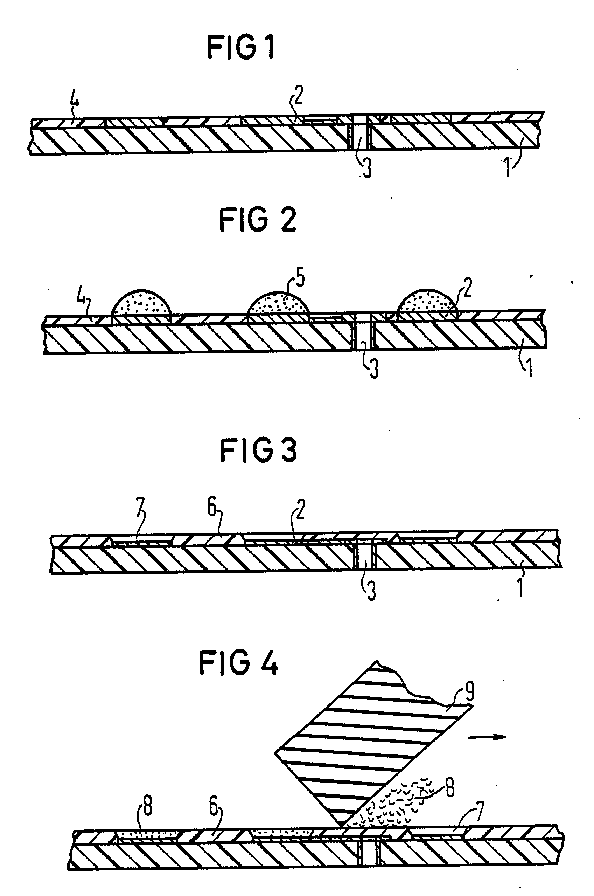

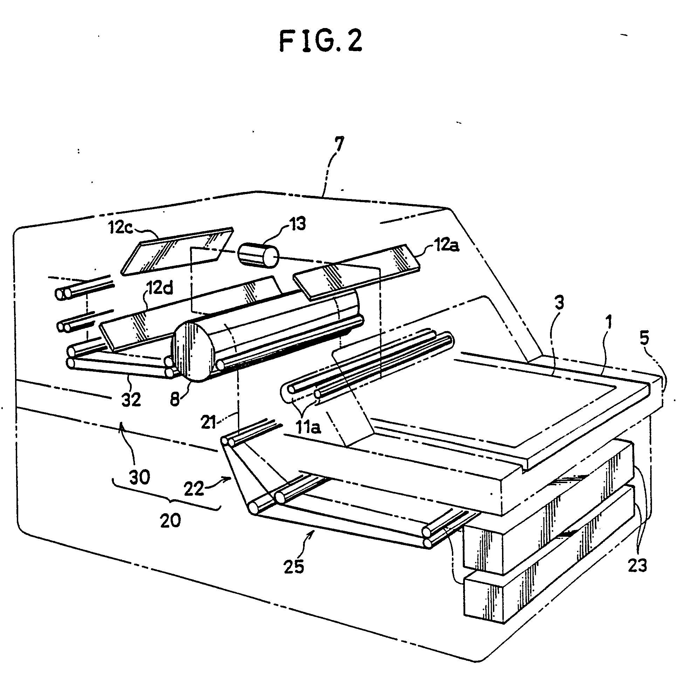

FIG 1 zeigt den bekannten Aufbau einer Leiterplatte mit einem Trägermaterial 1, auf dem Kontaktflecken 2 angeordnet sind, die über Leiterbahnen untereinander bzw. über Durchkontaktierungen 3 mit Leiterbahnen und Kontaktflecken auf der anderen Seite der Leiterplatte verbunden sind. Zwischen den Kontaktflecken 2 befindet sich in ebenfalls bekannter Weise sogenannter Lötstopplack 4. Bei der Darstellung von FIG 1 und auch den nachfolgenden Figuren wurde die Leiterplatte zur besseren Übersicht nur einlagig dargestellt, die Ausführungen gelten aber selbstverständlich auch für mehrlagige Leiterplatten.

Leiterplatten dieser Art werden in der Regel mit dünn vorverzinnten Leiterflecken 2 aus der Leiterplattenfertigung angeliefert.

In einem nachfolgenden Fertigungsschritt wird dann auf die zum Bestücken mit SMD-Bausteinen vorgesehenen Kontaktflecken 2 durch ein Sieb-/oder Schablonendruckverfahren Lotpaste 5 aufgebracht, wie es FIG 2 schematisch zeigt. Da das Aufbringen solcher Lotpaste 5 durch Sieb-/oder Schablonendruck ein an sich bekannter Vorgang ist, wurde auf seine ins Einzelne gehende Darstellung hier verzichtet. Erkennbar aus FIG 2 ist aber die anschließende Lage der Lotpaste 5 auf der Oberfläche der Kontaktflecken 2 und in der gleichen Ebene wie die Oberfläche des Lötstopplackes 4. Durch diese Tatsache kann es zu den oben erwähnten Schwierigkeiten wie Verrutschen der SMD-Bausteine, Kurzschlußgefahr und ähnlichem kommen. Ferner ist aus den FIG 1 und 2 ersichtlich, daß die Durchkontaktierungen 3 nicht mit Lotpaste versehen werden und deshalb beim nachfolgenden Reflow-Lötprozeß offen bleiben.

Demgegenüber zeigt FIG 3 den Aufbau einer bekannten verbesserten Leiterplatte, die in ihren Grundelementen, nämlich einer Trägerplatte 1, den Kontaktflecken 2 und eventuellen Durchkontaktierungen 3 mit der Leiterplatte von FIG 1 übereinstimmt. Der wesentliche Unterschied dieser Leiterplatte gegenüber der bekannten Leiterplatte nach FIG 1 ist darin zu sehen, daß die Oberfläche des Trägermaterials 1 der Leiterplatte durch eine Abdeckschicht 6 abgedeckt ist, in der die Kontaktflecken 2 - und eventuelle Prüfpunkte - ausgespart sind. Dies ist in FIG 3 links mit der Aussparung 7 angedeutet. Es ist ferner ersichtlich, daß sich dadurch im Bereich der Kontaktflecken 2 Vertiefungen ergeben und eventuelle Durchkontaktierungen 3 durch die Abdeckschicht 6 verschlossen sind.

FIG 4 zeigt schließlich, daß sich erfindungsgemäß in den Vertiefungen 7 der Leiterplatte streichförmiges Kontaktierungsmaterial 8 befindet, und wie dieses im Gegensatz zu dem in FIG 2 angedeuteten bekannten Sieb-/oder Schablonendruckverfahren und im Gegensatz zu der bekannten verbesserten Leiterplatte in einfacherer Weise aufgebracht werden kann. Das Kontaktierungsmaterial - z.B. in Form von Lotpaste - wird auf die Abdeckschicht 6 aufgetragen und mit Hilfe einer Rakel 9 in die Aussparungen 7 gedrückt. Anstelle von Lotpaste kann aber als Kontaktierungsmaterial auch leitfähiger Kleber verwendet und in gleicher Weise mit Hilfe einer Rakel in die Aussparungen 7 der Abdeckschicht 6 gedrückt werden.

Die Oberfläche des Kontaktierungsmaterials 8 in den Aussparungen 7 liegt dann zwar in etwa in der gleichen Ebene wie die Oberfläche der Abdeckschicht 6. Wegen der Verwendung von streichfähigem Material als Kontaktierungsmaterial können aber die Anschlüsse der SMD-Bausteine leicht in das weiche Material 8 hineingedrückt werden. Sie sind dann dort gegen Verrutschen gesichert. Die erfindungsgemäße Leiterplatte und das Verfahren zu ihrer Herstellung haben den Vorteil, daß durch die Verwen dung von streichfähigem Kontaktierungsmaterial wie Lotpaste oder leitfähigem Kleber in den Aussparungen der Abdeckschicht das Kontaktierungsmaterial für alle Anschlüsse der SMD-Bausteine gleich hoch ist und dadurch eine gleichgute Benetzung und Kontaktierung der Anschlüsse erreicht wird.

Im Falle der Verwendung von Lotpaste als Kontaktierungsmaterial wird die Leiterplatte nach dem Bestücken mit den SMD-Bausteinen zumindest im Bereich der Kontaktflecken soweit erwärmt bis die Lotpaste zu Lot umgeschmolzen ist.

Im Falle der Verwendung von leitfähigem Kleber kann diese Erwärmung entfallen.

**Ansprüche**

1. Leiterplatte zum Bestücken mit SMD-Bausteinen, aus einem - gegebenenfalls mehrlagigen - Trägermaterial mit auf mindestens einer Oberfläche angeordneten Kontaktflecken für die SMD-Bausteine und einer auf der Oberfläche des Trägermaterials angeordneten nichtmetallischen Abdeckschicht, in der die Kontaktflecken und eventuelle Prüfpunkte ausgespart sind, sowie in den Aussparungen befindlichem Kontaktierungsmaterial, **dadurch gekennzeichnet,** daß als Kontaktierungsmaterial ein streichfähiges Material wie Lotpaste (8) oder leitfähiger Kleber vorgesehen ist.

2. Leiterplatte nach Anspruch 1, **dadurch gekennzeichnet,** daß die Oberfläche des in den Aussparungen (7) befindlichen Kontaktierungsmaterials (8) zunächst etwa in der gleichen Ebene wie die Oberfläche der Abdeckschicht (6) liegt.

3. Leiterplatte nach einem der Ansprüche 1 oder 2, **dadurch gekennzeichnet,** daß die Aussparungen (7) in der Abdeckschicht (6) ausgeschnitten, ausgeätzt, eingeprägt, eingespritzt, eingepreßt oder - z.B. mit Hilfe eines Lasers ausgebrannt sind.

4. Leiterplate nach einem der Ansprüche 1 bis 5, **dadurch gekennzeichnet,** daß die Abdeckschicht (6) aus einer Folie besteht.

5. Leiterplatte nach einem der Ansprüche 1 bis 4, **dadurch gekennzeichnet,** daß die Abdeckschicht (6) aus dem gleichen Material wie die Trägerschicht besteht.

6. Verfahren zum Herstellen von Leiterplatten nach einem der Ansprüche 1 bis 5, **dadurch gekennzeichnet,** daß das Kontaktierungsmaterial (8) auf die Abdeckschicht aufgetragen und mit Hilfe einer Rakel in die Aussparungen der Abdeckschicht gedrückt wird.

7. Verfahren nach Anspruch 6, **dadurch gekennzeichnet,** daß bei Verwendung von Lotpaste als Kontaktierungsmaterial diese in den Aussparungen (7) der Abdeckschicht (6) umgeschmolzen wird.

EP 0 307 766 A1

# FIG 1

# FIG 2

# FIG 3

# FIG 4

# FIG.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | GB-A-2 134 026 (ALLEN BRADLEY INTERNATIONAL LTD) * Seite 1, Zeilen 83-102; Figur 4b * --- | 1,2,7 | H 05 K 3/40 H 05 K 3/34 |
| X | PATENT ABSTRACTS OF JAPAN, Band 9, Nr. 256 (M-421)[1979], 15. Oktober 1985; & JP-A-60 106 696 (MATSUSHITA DENKI SANGYO K.K.) 12-06-1985 * Zusammenfassung * --- | 1 | |
| A | DE-A-3 305 952 (ETA S.A.) * Seite 6, Zeile 25 - Seite 7, Zeile 30 * ----- | 1,3,7 | |

| RECHERCHIERTE SACHGEBIETE (Int. Cl.4) |
|---|
| H 05 K |

Der vorliegende Recherchenbericht wurde für alle Patentansprüche erstellt

| Recherchenort | Abschlußdatum der Recherche | Prüfer |
|---|---|---|
| DEN HAAG | 15-12-1988 | SCHUERMANS N.F.G. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
 
& : Mitglied der gleichen Patentfamilie, übereinstimmendes Dokument